# EUROPÄISCHE PATENTANMELDUNG

(11) **EP 2 854 493 A2**
(43) Veröffentlichungstag der Anmeldung: **01.04.2015**
(21) Anmeldenummer: 14185900.9
(22) Anmeldetag: 23.09.2014
(51) Int. Cl.: H05K 7/18

(54) **Schaltschranksystem**

(30) Priorität: 26.09.2013 DE 102013110670
(71) Anmelder: Rittal GmbH & Co. KG, 35745 Herborn (DE)
(72) Erfinder: Holighaus, Heiko, 35713 Eschenburg (DE); Böhme, Siegfried, 06766 Wolfen (DE)
(74) Vertreter: Tönhardt, Marion

(57) **Zusammenfassung**

Die Erfindung beschreibt ein Schaltschranksystem, mit wenigstens einem Rahmengestell (1), das die Kontur einer Schaltschrankeinheit definiert, wenigstens einer Entwärmungskomponente zum Abführen oder Ableiten von Wärme, die von in oder an dem Rahmengestell angeordneten elektrischen oder elektronischen Komponenten erzeugt wird, und Schnittstellen zur Kommunikation mit der Umgebung des Schaltschranksystems, wobei das Rahmengestell (1) aus vertikal und horizontal anzuordnenden Profilen-(10) mit Systemlochung aufgebaut ist, die an ihren Enden senkrecht zur Profilrichtung abgelängt sind, wobei die Profile Hohlprofile sind und der Profilquerschnitt aller Profile (10) des Rahmengestells (1) identisch ist, und wobei jeweils drei der Profile (10) mittels Eckverbindern (20) oder ohne senkrecht zueinander positioniert sind, wobei im Verbindungsbereich der Profile (10) in Belastungsrichtung verlaufende Schweißnähte angebracht sind.

## Beschreibung

Die Erfindung betrifft ein Schaltschranksystem, mit wenigstens einem Rahmengestell, das die Kontur einer Schaltschrankeinheit definiert, wenigstens einer Entwärmungskomponente zum Abführen oder Ableiten von Wärme, die von in oder an dem Rahmengestell angeordneten elektrischen oder elektronischen Komponenten erzeugt wird, und Schnittstellen zur Kommunikation mit der Umgebung des Schaltschranksystems.

Ein Rahmengestell mit seinen vertikal und horizontal anzuordnenden Profilen weist üblicherweise eine Systemlochung auf, wie sie aus dem Stand der Technik bekannt ist. Üblich ist eine 19"-Systemlochung, aber auch die metrische Systemlochung wird verwendet. Eine wichtige Forderung ist die Anreihbarkeit, um Schaltschranksysteme zu bilden.

Schaltschranksysteme, die somit auf einem oder mehreren Rahmengestellen basieren, sind seit langem bekannt. So beschreibt die DE 10 2006 036 487 B4 ein Rahmengestell für Anreihschrankanordnungen, das sozusagen das Grundgerüst einer Schaltschrankeinheit bildet, die durch einen entsprechenden Innenausbau vervollständigt wird. Dem Rahmengestell kommt daher eine zentrale Bedeutung für den Aufbau eines Schaltschranksystems zu, insbesondere auch, was die Montagemöglichkeiten betrifft.

Als "Entwärmungskomponente" zum Abführen oder Ableiten von Wärme kommen Klimageräte, und zwar sowohl aktive als auch passive sowie Kombinationen aus diesen, in Betracht, aber auch Maßnahmen, die die gezielte Luftführung betreffen.

Bei der Kühlung von Schaltschranksystemen ist es ein fortwährendes Problem, dass die Umgebungstemperaturen der Schaltschränke über den Jahresverlauf sowie die Verlustleistungen und die damit einhergehende Abwärme der in den Schaltschränken aufgenommenen Komponenten starken Schwankungen ausgesetzt sein können, wobei unabhängig von diesen Schwankungen die in den Innenräumen der Schaltschränke vorherrschende Lufttemperatur unterhalb eines bestimmten Wertes gehalten werden muss, um zu vermeiden, dass die darin enthaltenen elektrischen oder elektronischen Komponenten Schaden nehmen. Es sind diverse Ansätze bekannt, die auf kleinstem Raum hohe Kühlleistungen erbringen, z. B. das im Rittal-Handbuch 33 auf Seite 464 beschriebene, passiv arbeitende Gerät "TopTherm LCP Passive CW", das serverinterne Lüfter für die Erzeugung des erforderlichen Luftstroms nutzt und so auch in der Lage ist, Hotspots zu absorbieren, ohne dass das Klimatisierungskonzept des Schaltschranksystems grundsätzlich zu ändern. Die für die Schaltschrankkühlung verwendeten Klimageräte, seien es passive oder aktive Geräte, weisen jedoch stets einen schmalen Kühlleistungsbereich auf, in welchem sie energieeffizient arbeiten.

So sind verschiedene Konzepte entwickelt worden, die diesem Umstand Rechnung tragen sollen.

Die nicht vorveröffentlichte DE 10 2012 108 108.5 beschreibt einen Schaltschrank mit einem Kühlgerät für die passive Schaltschrankkühlung unter Verwendung eines Luft-Luft-Wärmetauschers, der zusammen mit einem geschlossenen Leitungssystem ein zu einer sogenannten "Heatpipe" funktional ähnliches Bauteil bildet. Die Kühlwirkung des Wärmetauschers beruht dabei auf der Ausnutzung des Effekts, wonach das verdampfende Kühlmittel bei dem Übergang von dem flüssigen in den gasförmigen Aggregatzustand seiner Umgebung Wärme entzieht und dieselbe Wärmemenge an ihre Umgebung wieder abgibt, wenn sie von dem gasförmigen in den flüssigen Aggregatszustand zurückkehrt. Dadurch, dass das Verdampfen des Kühlmittels in einem zweiten Abschnitt des Wärmetauschers und das Kondensieren des Kühlmittels in einem ersten Abschnitt des Wärmetauschers stattfinden, bildet sich ein Nettowärmefluss von dem zweiten Abschnitt in den ersten Abschnitt des Wärmetauschers aus. Um die Redundanz des Kühlgerätes zu erhöhen, kann neben dem passiven Kühlkreislauf auch ein zusätzlicher aktiver Kühlkreislauf vorgesehen sein, welcher bedarfsweise zuzuschalten ist. Das Klimagerät nutzt aus, dass ein Großteil der Kühlleistung auch bei hohen Verlustleistungen sowie Umgebungslufttemperaturen passiv, d. h. nur mit Hilfe einer Heatpipe, bereitgestellt werden kann.

Derartige kombinierte Klimageräte, welche sowohl einen aktiven Kühlkreislauf, die einen Verdichter getriebenen Kühlkreislauf, und einen passiven Kühlkreislauf umfassen, werden auch als "Hybridkühlgeräte" oder "Hybridklimageräte" bezeichnet. Ein weiteres Beispiel eines Hybridklimagerätes ist in der ebenfalls nicht vorveröffentlichten DE 10 2012 108 109.3 beschrieben.

Ferner sind Klimageräte beziehungsweise Kühlgeräte bekannt, die auch im Teillastbereich arbeiten können, wobei aber als nachteilig anzusehen ist, dass sie für maximale Effizienz bei maximaler Kühlleistung laufen und somit im Teillastbereich in einem weniger effizienten AnAus-Betrieb laufen. Eine energieeffiziente Kühlung des Innenraums von Schaltschränken gelingt gemäß der nicht vorveröffentlichten DE 10 2012 007 081.6 dadurch, dass ein Luft-Wasser-Wärmetauscher und/oder ein Verdampfer vorgesehen ist, der in Abhängigkeit von der von dem Luft-Luft-Wärmetauscher erzeugten Vorkühlung eine bedarfsweise Nachkühlung der zugeleiteten Luft bereitstellt. Die nicht vorveröffentlichte DE 10 2012 108 110.7 verwendet dazu ein Klimagerät mit einem ersten geschlossenen Kühlmittelkreislauf und einem von dem ersten Kühlmittelkreislauf fluidisch getrennten zweiten geschlossenen Kühlmittelkreislauf, wobei der erste Kühlmittelkreislauf eine Kältemaschine oder ein Kaltwassersatz und der zweite Kühlmittelkreislauf eine Wärmerohranordnung oder einen Zwei-Phasen-Thermo-Siphon aufweist.

Andere Entwicklungen gehen in Richtung selbsttragender Kühlmodule, wie sie beispielsweise in der DE 10 2011 015 859 A1 beschrieben sind. Der selbsttragende Kühlmodulkörper ist aus geschäumten Kunststoffmaterial aufgebaut, wobei die Komponenten so in den Kühlmodulkörper eingelassen sind, dass sie auch in einer gegenüber der normalen Betriebsposition um 180° gedrehten Betriebsposition betriebsfähig zusammenwirken. Damit steht ein Kühlmodul zur Verfügung, das ohne irgendwelche Umrüstungen in verschiedensten Einbausituationen einsetzbar ist.

Weitere Maßnahmen bestehen darin, die Luftführung innerhalb eines Schaltschrankes gezielt zu beeinflussen. Beispielsweise können Dachentlüftungen, auch ohne Lüftungsmotoren, vorgesehen sein, Lüftungsklappen oder dergleichen.

Bei Schaltschränken sind die sich aufgrund ihrer Verlustleistung aufheizenden und kühlbedürftigen Komponenten häufig auf einer Montageplatte mehr oder weniger in einer Ebene übereinander und nebeneinander angeordnet. Im oberen Bereich des Schaltschrankes wird Warmluft aus dem Schaltschrankinnenraum abgeführt, durch einen Wärmetauscher eines Kühlgerätes hindurch geführt, dort abgekühlt, und als Kaltluft durch den Kaltlufteinlass im unteren Bereich des Schaltschrankes wieder eingeblasen. Es ergibt sich im Schaltschrankinneren ein Temperaturgefälle von oben nach unten, so dass die tiefgelegenen Komponenten mit der kühleren Luft angeströmt werden, während darüber angeordnete Komponenten mit bereits durch die Abwärme der jeweils tiefer gelegenen Komponenten aufgewärmter Luft umströmt werden. Es kann auch vorkommen, dass höher gelegene Komponenten aufgrund der vertikalen Luftströmungsrichtung im Windschatten tiefer gelegener Komponenten liegen, was die Kühlung der höher gelegenen Komponenten weiter verschlechtert. Auch kann es vorkommen, dass im oberen Bereich des Schaltschrankes Temperaturen erreicht werden, welche über einer oberen Grenztemperatur für die mittlere Schaltschranktemperatur liegen.

Daher schlägt die DE 10 2013 101 507.7, die nicht vorveröffentlicht ist, vor, kühlungsbedürftige Komponenten im Schaltschrankinnenraum gezielt anzuströmen, indem ein kombinierter Kabel- und Luftkanal verwendet wird, durch den auch ein verbessertes Kabelmanagement erreicht wird. Hier sind ein Luftkanal und ein daran angrenzender Kabelkanal vorgesehen, wobei für die einfache Montage vorgesehen ist, dass eine Längsseite des Kabelkanals eine abnehmbar verrastete Verschlussseite ist. Der Luftkanal kann eine Mehrzahl wahlweise aufbrechbarer Durchbrüche aufweisen, so dass der Benutzer je nach Anwendungsfall diese Sollbruchstellen öffnen kann, wenn sie nahe an den zu kühlenden Komponenten angeordnet sind. Auch eine Anpassung des Kühlluftvolumenstroms ist möglich, wenn die Zahl der geöffneten Durchbrüche entsprechend angepasst ist.

Ein anderes System ist in der WO 2013/023633 A2 beschrieben, dort im Zusammenhang eines Kühlgerätes für den Aufbau auf einem Dach eines Schaltschrankes beziehungsweise seines Rahmengestells, wobei die Lüftungslamellen vor mehreren Luftaustrittsöffnungen unabhängig manuell oder motorisch betrieben werden können, um beispielsweise in thermisch besonders belastete Bereiche gezielt eine große Kaltluftmenge zu leiten, während andere Bereiche nur wenig oder gar nicht angeströmt werden.

All diese Konzepte einer neuen Kühlgerätegeneration können bei dem erfindungsgemäßen Schaltschranksystem einzeln oder in Kombination eingesetzt werden.

Unter "Schnittstellen zur Kommunikation mit der Umgebung des Schaltschranksystems" sollen insbesondere Anschlussstellen für die Energieversorgung, wie Stromzufuhr, und Kühlmittelzufuhr bzw. Kühlmittelableitung verstanden werden, aber auch Einrichtungen zur Datenkommunikation, wie sie für den Betrieb eines Schaltschranksystems erforderlich-sind.

Wegen der zentralen Bedeutung der Rahmengestelle für die Infrastruktur eines Schaltschranksystems sollen diese im Folgenden näher diskutiert werden.

Ein Rahmengestell ist beispielsweise aus der DE 10 2006 003 770 A1 bekannt. Dabei ist ein dem Schrankinnenraum zugewandter Abschnitt der Wand der Rahmenprofile der Rückversetzung liegt ein dem Schrankinnenraum zugewandter Oberflächenabschnitt des Verbindungsstückes frei. In diesem ist eine durch das Verbindungsstück hindurchführende Bohrung ausgebildet. Eine solche Bohrung lässt sich für eine Schraubverbindung des Rahmengestells mit einem Trägersockel oder einem Rahmengestell eines benachbarten Schaltschrankes nutzen.

Ein weiteres Rahmengestell für einen Schaltschrank ist aus der DE 41 35 108 A1 bekannt. Damit in den Eckbereichen des Rahmengestells die Anlagestege einen geschlossenen Anlagerahmen bilden, sind die Stirnseiten von einzelnen Rahmenprofilen an bestimmten Stellen ausgespart, um die dafür erforderliche Überlappung rechtwinklig aufeinanderstoßender Rahmenprofile zu erhalten.

Im Zuge der Vereinfachung des Herstellungsprozesses bei einem Rahmengestell wäre es wünschenswert, einerseits identische, andererseits gerade abgelängte Profile zu verwenden. Die Verbindung derartiger Rahmenprofile ist allerdings problematisch.

Es zeigt die DE 195 36 925 C2 ein Rahmengestell für einen Schaltschrank, das aus Rahmenprofilen mit identischen Profilquerschnitt und Eckverbindern zusammengesetzt ist, wobei die Rahmenprofile als offene oder geschlossene Hohlprofilabschnitte ausgebildet sein können, so dass sie Steckaufnahmen für an den Eckverbindern angebrachte Steckelemente bilden. Die Steckelemente sind an einem Basiskörper des Eckverbinders angebracht und bestehen, wie der Basiskörper selbst, aus Metall. Dies ermöglicht es, dass die Steckelemente des Basiskörpers vor dem Einführen in die Steckaufnahmen mit einem wärmebeständigen Zweikomponenten-Metall-Klebstoff versehen werden können, der nach einer gewissen Zeit aushärtet und so den Eckverbinder fest und unlösbar mit den Rahmenprofilen verbindet. Dabei ist zwingend notwendig, dass die Steckelemente als Bolzen ausgeführt sind, die nicht dem Querschnitt der Steckaufnahmen entsprechen, um eine ausreichende Menge an Klebstoff in das Profilinnere transportieren zu können.

Die DE 195 37 015 C1 betrifft ein Rahmengestell für einen Schaltschrank, das ähnlich aufgebaut ist, wobei jedoch die Eckverbinder auf drei im rechten Winkel zueinander stehenden Verbindungsflächen mit Vertiefungen versehen sind, die im Querschnitt an die Außenkontur oder den Querschnitt der Rahmenprofile angepasst sind. Damit lässt sich mit beliebig gestalteten Rahmenprofilen ein Rahmengestell aufbauen, allerdings ist der Aufbau eines derartigen Eckverbinders komplex. Auch hier lässt sich der Halt der Rahmenprofile in den Vertiefungen der Eckverbinder dadurch verbessern, dass die Rahmenprofile mit ihren Enden in die Vertiefungen eingeklebt sind.

Insbesondere bei Schwerlastschränken wird aber die Anforderung nach erhöhter Stabilität auch im Eckbereich des Rahmengestelles gestellt, die eine Klebverbindung in aller Regel nicht erfüllen kann.

Daher ist es üblich, im Bereich der Eckverbinder zu schweißen, wobei aber regelmäßig, wie beispielsweise aus der CN 20617567 U bekannt, Horizontalprofile verwendet werden, die einen von dem der Vertikalprofile unterschiedlichen, weniger komplexen Profilquerschnitt aufweisen, da sie für den Innenausbau einer Schaltschrankeinheit nachrangige Bedeutung haben. So ist es möglich, eine stabile Verbindung im Eckbereich zu erhalten, wenn auch der Schweißprozess noch aufwändig erscheint.

Auch die eingangs erwähnte DE 10 2006 036 487 B4 bedient sich eines im Wesentlichen kubischen Eckstücks, das auf der Rahmengestellinnenseite umlaufend mit den Profilen verschweißt ist. Weitere Schweißnähte sind dort angebracht, wo Kanten des Profils direkt aufeinanderstoßen. Bei der Verschweißung ist eine genaue Positionierung der Komponenten nur sehr aufwändig zu erreichen. Zudem kompliziert die Vielzahl der Schweißnähte den Fertigungsprozess.

Ein geschweißtes Rahmengestell, das ohne Eckverbinder aufgebaut ist, ist in der DE 196 47 790 C2 gezeigt. Zur Herstellung des aus Horizontalprofilen aufgebauten Sockel- oder Dachrahmens wird ein einziges Stanz-Biegeteil verwendet, so dass die Horizontalprofile einstückig miteinander verbunden und zueinander fixiert sind. Der Eckbereich des Rahmens ist an die Geometrie des Vertikalprofils angepasst, insbesondere ist eine Auflagefläche für das Vertikalprofil geschaffen. Die Gestaltung des Eckbereichs trägt maßgeblich zu den Kosten des Rahmengestells bei.

Es ist daher die Aufgabe der Erfindung, ein Rahmengestell für das Schaltschranksystem, wie eingangs beschrieben, so zu gestalten, dass im Eckbereich des Rahmengestells, d. h. im Verbindungsbereich der Profile, eine stabile Aneinanderfügung der Profile sichergestellt ist. Insbesondere soll der Fertigungsprozess optimiert werden, indem die Anzahl der Schweißverbindungen und die Anzahl der Stanzungen beziehungsweise Schnitte beim Profil für das Bilden der Eckverbindung so gering wie möglich gehalten wird.

Diese Aufgabe wird gemäß Anspruch 1 bzw. gemäß Anspruch 7 einerseits dadurch gelöst, dass im Verbindungsbereich der Profile in Belastungsrichtung verlaufende Schweißnähte angebracht sind. Dabei ist es unerheblich, ob Eckverbinder eingesetzt werden oder nicht.

Die Verwendung von Eckverbindern hat nun den Vorteil, dass die Profile gerade abgelängt und ohne großen Aufwand vor dem Schweißvorgang in Bezug aufeinander positioniert werden können.

Es ist aber ebenso erfindungsgemäß vorgesehen, dass die Profile im Verbindungsbereich zumindest abschnittsweise abgeschrägt sind und die relative Positionierung durch diese Schrägen definiert ist.

In beiden Fällen können dann die in Belastungsrichtung verlaufenden Schweißnähte angebracht werden, ohne dass eine Verschiebung der Profile befürchtet werden muss.

Ein Rahmengestell gemäß der vorliegenden Erfindung besteht somit nach dem ersten Aspekt aus Profilen, die an ihren Enden senkrecht zur Profilrichtung abgelängt sind, wobei die Profile Hohlprofile sind und der Profilquerschnitt aller Profile des Rahmengestells identisch ist. Dabei sind jeweils drei der Profile mittels Eckverbindern senkrecht zueinander positioniert, die in mindestens zwei der Profile eingreifen. Die Eckverbinder nehmen einen Teil der Kräfte auf, denen das Rahmengestell bei vollständiger Bestückung mit elektrischen oder elektronischen Komponenten oder auch mit Klimageräten ausgesetzt ist. Die Anzahl der Schweißverbindungen kann daher minimiert werden, da sie lediglich überhöhte Belastungen auffangen müssen. Diese können in einem computergestützten Konfigurationsprozess ermittelt und berücksichtigt werden. Die entsprechende Software kann auch dazu ausgelegt sein, eine optimale Anordnung der Komponenten zu finden, wobei gegebenenfalls Gesichtspunkte bezüglich der Entwärmung zu beachten sind.

Die Stabilität des Rahmengestells wird maßgeblich auch durch die Geometrie der verwendeten Profile bestimmt. Bevorzugt ist daher vorgesehen, dass die Profile des Rahmengestells einen gerade verlaufenden Verbindungssteg aufweisen, von dem aus sich, symmetrisch zu der Längsrichtung des Profils, auf beiden Seiten jeweils eine Hohlkammer erstreckt. Ein solches Profil hat sich als verwindungssteif erwiesen.

Außerdem können weiter vorteilhaft ausgestaltete Eckverbinder eingesetzt werden, die dadurch gekennzeichnet sind, dass sie Zapfen aufweisen, wobei der Querschnitt der Zapfen dem Querschnitt einer Hohlkammer des Profils entspricht. Damit wird auch die Torsionsstabilität der Eckverbinder erhöht.

Man kann dies auch durch eine spezielle Gestaltung des Querschnitts des Profils erreichen, wenn nämlich der Querschnitt einer Hohlkammer des Profils einen Bereich mit L-förmiger Kontur umfasst und der Querschnitt der Zapfen dem Bereich mit L-förmiger Kontur entspricht. Der Zapfen wirkt dann mit mindestens drei Wandabschnitten einer Hohlkammer zusammen.

Besonders vorteilhaft ist dies, wenn die Querschnittsfläche der Hohlkammer größer ist als die Querschnittsfläche des Zapfens. Bei sinnvoller Ausgestaltung der Profile sind dann auch die Durchbrüche der Systemlochung im Innenraum des Rahmengestells praktisch bis zum Boden frei und stehen für die Montage beispielsweise einer Bodenplatte zur Verfügung.

Ferner sollte vorgesehen sein, dass in die Eckverbinder des Rahmengestells jeweils eine Gewindeöffnung zur Aufnahme einer Kranöse oder eines Standfußes integriert ist.

Nach einem zweiten Aspekt der Erfindung ist bei einem Schaltschranksystem das Rahmengestell wiederum aus vertikal und horizontal anzuordnenden Profilen mit Systemlochung aufgebaut ist, die an ihren Enden zumindest abschnittsweise unter einem vorbestimmten Winkel oder um vorbestimmte Winkel zur Profilrichtung, der bzw. die ungleich 90° ist, abgelängt sind. Die Profile sind Hohlprofile, der Profilquerschnitt aller Profile des Rahmengestells ist identisch. Die Ablängungen sind so gewählt, dass jeweils drei der Profile senkrecht zueinander aneinanderliegend zu positionieren sind, um eine Ecke zu bilden, wobei im Verbindungsbereich der Profile in Belastungsrichtung verlaufende Schweißnähte angebracht sind. Die Wahl der Ablängungen sowie ihre Richtung ist dadurch bestimmt, dass die Länge der Schweißnähte möglichst gering gehalten wird. Dies kann einerseits durch das gewählte Profil, andererseits durch dessen Konturierung erreicht werden.

Es hat sich wieder gezeigt, dass Profile für ein Rahmengestell in einem Schaltschranksystem gemäß der vorliegenden Erfindung geeignet sind, einen gerade verlaufenden Verbindungssteg aufweisen, von dem aus sich, symmetrisch zu der Längsrichtung des Profils, auf beiden Seiten jeweils eine Hohlkammer erstreckt. Bei einem derartigen Profil kann eine stabile Fügekontur dadurch erreicht werden, dass bei wenigstens einem der Profile die winklige Ablängung lediglich über zumindest eine der Hohlkammern erfolgt. Die durch den Verbindungssteg vermittelte Festigkeit bleibt erhalten.

Wie bei der Ausgestaltung nach dem ersten Aspekt der Erfindung kann vorgesehen sein, dass in den Bereich jeder Ecke des Rahmengestells jeweils eine Gewindebohrung zur Aufnahme einer Kranöse oder eines Standfußes integriert ist. Besonders vorteilhaft werden als Aufstandsfläche Schaltschranksockel verbaut, wie sie in der WO 2012/116672 A1 und in der WO 2012/116673 A1 beschrieben sind.

Im Folgenden soll die Erfindung lediglich beispielhaft anhand der beigefügten Zeichnung näher erläutert werden. Dabei ist zu beachten, dass die Figuren die tatsächlichen Abmessungen nicht notwendigerweise maßstabsgetreu wiedergeben. Ferner sind manche Einzelheiten weggelassen, um das Verständnis der Erfindung zu erleichtern. Wenn Verfahrensabläufe angegeben sind, versteht sich, dass diese nicht notwendigerweise in der angegebenen Reihenfolge ausgeführt werden müssen, wenn andere Abfolgen von Verfahrensschritten sinnvoll sind. Es zeigt:
- Figur 1: ein schematisiertes Schaubild eines Schaltschranksystems mit seinen wesentlichen Komponenten;
- Figur 2: eine perspektivische Darstellung einer Eckverbindung eines Rahmengestells gemäß dem ersten Aspekt der vorliegenden Erfindung;
- Figur 3: eine Querschnittsdarstellung eines möglichen Profils, das für ein solches Rahmengestell verwendet werden kann;
- Figur 4: eine Querschnittsdarstellung des Profils im Bereich eines eingesetzten Zapfens eines Eckverbinders nach einer ersten Ausführungsform;
- Figur 5: eine Querschnittsdarstellung des Profils mit eingesetzten Zapfen eines Eckverbinders gemäß einer zweiten Ausführungsform;
- Figur 6: eine Eckverbindung eines Rahmengestells gemäß dem zweiten Aspekt der vorliegenden Erfindung; und
- Figur 7: die Eckverbindung in einer gedrehten und verkippten Ansicht;
- Figur 8: eine Variante der Eckverbindung nach Figur 6; und
- Figur 9: eine Draufsicht auf ein Profil der Figuren 6 bis 8.

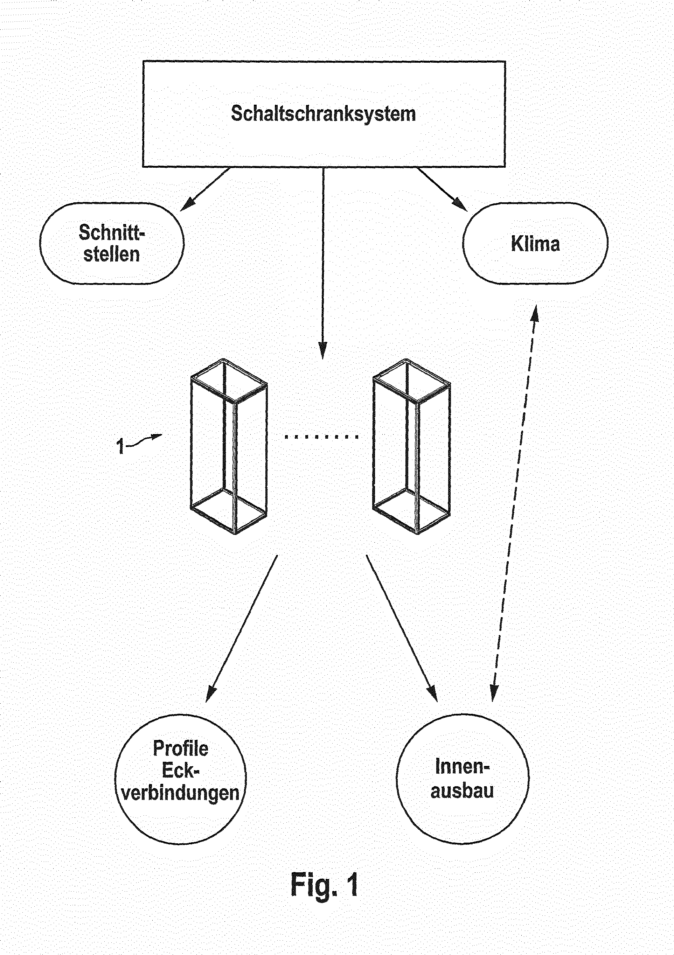

Ein Schaltschranksystem gemäß der vorliegenden Erfindung, wie es schematisiert in Figur 1 dargestellt ist, weist wenigstens ein Rahmengestell 1 auf, das aus vertikal und horizontal anzuordnenden Profilen aufgebaut ist, welche üblicherweise eine Systemlochung aufweisen, beispielsweise eine 19"-Systemlochung oder auch eine metrische Systemlochung. Das Rahmengestell 1 kann die Basis eines einzeln stehenden Schaltschranks bilden oder auch in Kombination mit weiteren Rahmengestellen 1, die aneinander gereiht werden, aufgebaut werden. Für eine solche Anreihschrankanordnung werden die Rahmengestelle 1 beispielsweise über Schraubverbindungen mit dem jeweils benachbarten Gestell verbunden.

An ein Rahmengestell 1 werden vielfältige Anforderungen gestellt. Unter anderem wird ein maximaler Einbauraum gefordert, um elektrische oder elektronische Komponenten relativ dicht unterzubringen, was wiederum bedingt, dass eine statische und dynamische Stabilität des Rahmengestells gegeben sein muss. Da im Regelfall ein Rahmengestell auch transportiert werden muss, sind Aufnahmen für Kranösen vorgesehen, die in den Eckbereichen des Rahmengestells 1 angebracht sind. Insofern besteht auch das Erfordernis, dass die Eckverbindungen eine ausreichende Stabilität aufweisen, um gegebenenfalls das Gewicht sogar einer bestückten Schaltschrankeinheit aufzunehmen.

Neben den elektrischen oder elektronischen Komponenten, die an Montageplatten verbaut werden, sind im Rahmengestell auch Entwärmungskomponenten untergebracht, die zum Abführen oder Ableiten von Wärme dienen, die von den elektrischen oder elektronischen Komponenten erzeugt wird. Eine wesentliche Komponente eines Schaltschranksystems ist daher auch ein optimiertes Klimamanagement, wie es mit der Bezeichnung "Klima" in Figur 1 angedeutet ist. Klimageräte, seien es aktive oder passive oder Kombinationen aus diesen, können dabei innerhalb oder außerhalb des Rahmengestells 1 angeordnet sein, beispielsweise auch in einem Doppelboden, auf dem das Rahmengestell 1 beziehungsweise die Rahmengestelle 1 aufgestellt sind. Klimamanagement bedeutet aber auch, gezielte Maßnahmen zur Luftführung zu treffen, wie es beispielsweise in der WO 2013/083421 A1 erläutert ist. Insofern ist verständlich, dass das Thema "Klima" nicht getrennt vom Thema "Innenausbau" eines Rahmengestells 1 betrachtet werden kann. Ein strichlierter Pfeil symbolisiert diese Wechselwirkung.

Nicht zuletzt umfasst das Schaltschranksystem Schnittstellen zur Kommunikation mit seiner Umgebung, beispielsweise für das Zu- und Abführen von Kühlflüssigkeit, Energiezufuhr, Datenleitungen und dergleichen. Auch diese gesamte Infrastruktur ist in und um das Rahmengestells 1 angesiedelt, so dass deutlich wird, dass dem Rahmengestell 1 beim Aufbau eines Schaltschranksystems eine zentrale Bedeutung zukommt. Im Folgenden soll daher der Aufbau eines Rahmengestells 1, wie es für ein erfindungsgemäßes Schaltschranksystem eingesetzt werden kann, näher erläutert werden, wobei neben der Profilgeometrie die Gestaltung der Eckverbindungen im Vordergrund steht.

Bei der vorliegenden Erfindung werden sowohl für die vertikal als auch für die horizontal anzuordnenden Profile identische Profile verwendet, d. h. solche, die zumindest in ihrem Profilquerschnitt übereinstimmen. Zweckmäßigerweise weisen die Profile auch eine übereinstimmende Systemlochung auf, so dass sie einfach in einem Rollstrangpress- und Stanzverfahren hergestellt werden können und lediglich abgelängt werden müssen.

Die vorliegende Erfindung bietet zwei Varianten an, eine, bei dem die Profile gerade, also senkrecht zur Profillänge, abgelängt werden, und eine weitere, bei der am jeweiligen Profilende Abschrägungen vorgesehen sind. Für jede Variante ist eine unterschiedliche Eckverbindung angegeben.

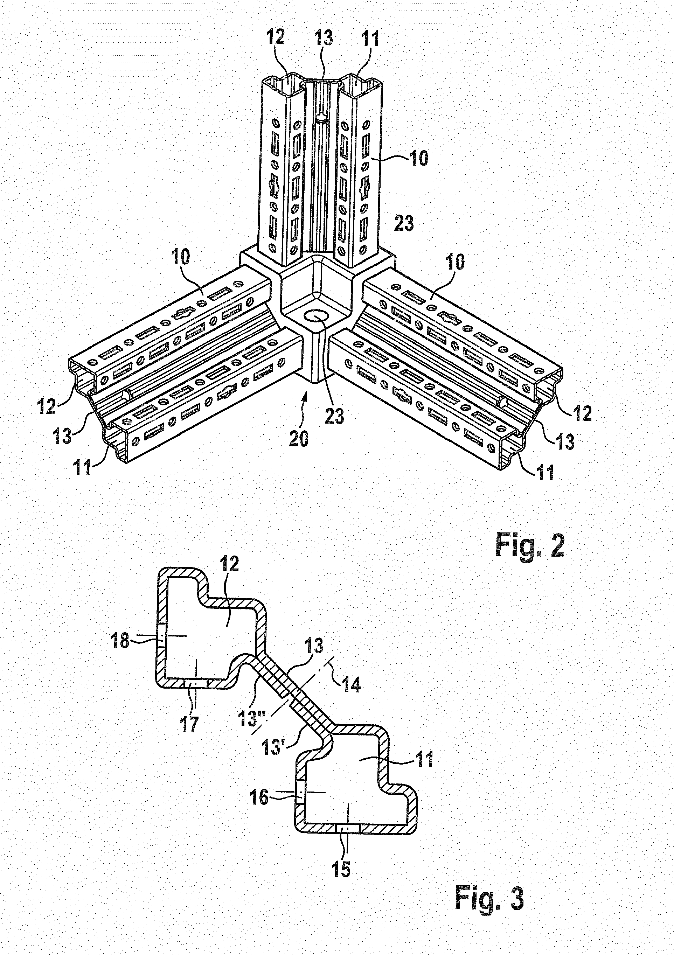

Gemäß dem ersten Aspekt der vorliegenden Erfindung wird ein Rahmengestell für ein Schaltschranksystem zur Verfügung gestellt, bei dem die Profile mittels eines Eckverbinders positioniert werden, wie es in Figur 2 gezeigt ist, woraufhin dann Verschweißungen in Belastungsrichtung angebracht werden, um die notwendige Stabilität der Eckverbindung sicherzustellen.

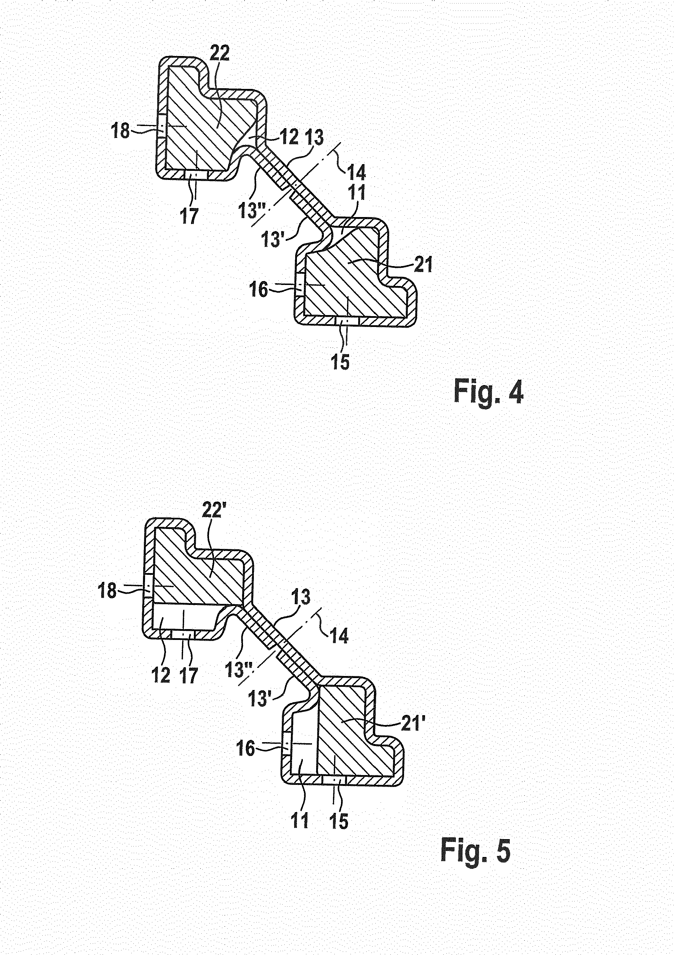

Figur 2 zeigt dabei Rahmenprofile 10, die in Breiten-, Tiefen- und Höhen-Anordnung eines Rahmengestells angeordnet sind und in den Eckbereichen mittels eines Eckverbinders 20, der in Zusammenhang mit den Figuren 4 und 5 noch näher beschrieben wird, verbunden sind. Die Rahmenprofile 10 bestehen aus Hohlkammern 11, 12, die durch einen Verbindungssteg 13 miteinander gekoppelt sind. Dieser Verbindungssteg 13 ist so gestaltet, dass er die Verwindungssteifigkeit des Profils 10 erhöht. Dazu ist er, wie es in Figur 3 besser zu erkennen ist, von den Hohlkammern 11, 12 abgehenden mit zwei Anlagestegen 13', 13" versehen, die symmetrisch zur Querschnittsdiagonalen 14 auf dem Verbindungssteg 13 geführt sind. Die Kammern 11, 12 dienen jeweils zur Aufnahme von Zapfen des Eckverbinders 20, die in der Figur 2 nicht dargestellt sind. Lochreihen in den Profilen, hier vereinfacht als Lochungen 15, 16, 17, 18 angedeutet, bilden eine Systemlochung für das Anbringen von z. B. Montageschienen, Haltern und dergleichen. Der Eckverbinder 20 umfasst überdies eine Gewindeöffnung 23 für die Aufnahme eines entsprechenden Gewindes einer Kranöse oder eines Standfußes. Es sind Schweißverbindungen nur dort vorgesehen, wo besondere Belastungen zu erwarten sind, wobei auch berücksichtigt wird, dass die Schweißverbindungen den optischen Eindruck nicht beeinträchtigen. So ist beispielsweise nicht vorgesehen, Schweißnähte an der Außenseite der Eckbereiche anzubringen. Auch Schweißverbindungen an dem Verbindungssteg 13 beziehungsweise an den Anlagestegen 13', 13 sollen vermieden werden. Vielmehr wird bevorzugt entlang den Kontaktlinien der Hohlkammern 11,12 zum Eckverbinder 20 geschweißt.

Figur 4 zeigt das Profil gemäß der Figur 3 in einem Querschnitt, wobei auch die Zapfen 21, 22 des Eckverbinders 20 veranschaulicht sind. Diese sind so ausgelegt, dass sie im Wesentlichen an die Innenkontur der Kammern 11, 12 angepasst sind, und können Hohlteile, wie gezeigt, oder massive Teile sein. Damit ergibt sich ein formschlüssiger Sitz, der für die Positionierung der Rahmenprofile 10 gegenüber dem Eckverbinder 20 ausgenutzt werden kann, wobei Schweißverbindungen in den Belastungsrichtungen angebracht werden, um die Anwendung auch als Schwerlastschaltschrank zu ermöglichen, ohne dass eine große Anzahl an Nähten zur Stabilisierung der Eckverbindung erforderlich ist.

Figur 5 zeigt, ebenfalls in einer Querschnittsansicht, eine Variante, bei der die Zapfen 21', 22' des Verbinders 20 den Innenraum der Kammern 11, 12 nicht vollständig ausfüllen, aber dennoch, aufgrund ihrer L-förmigen Gestaltung, an vier Seiten innerhalb der jeweiligen Kammer an dieser anliegen und somit, insbesondere durch die schwalbenschwanzförmige Ausgestaltung der Anlagestege 13', 13", stabil in den Kammern 11, 12 abgestützt sind. Vorteilhaft bei dieser Ausgestaltung ist, dass ein Teil 15, 17 der Lochungen 15, 16, 17, 18 auch im Bereich der Zapfen 21', 22' freiliegt, so dass sogar im Bereich der Zapfen 21', 22' des Eckverbinders 20 Befestigungselemente (nicht dargestellt) angebracht werden können, an denen beispielsweise Montageplatten oder Montageschienen festgelegt werden können.

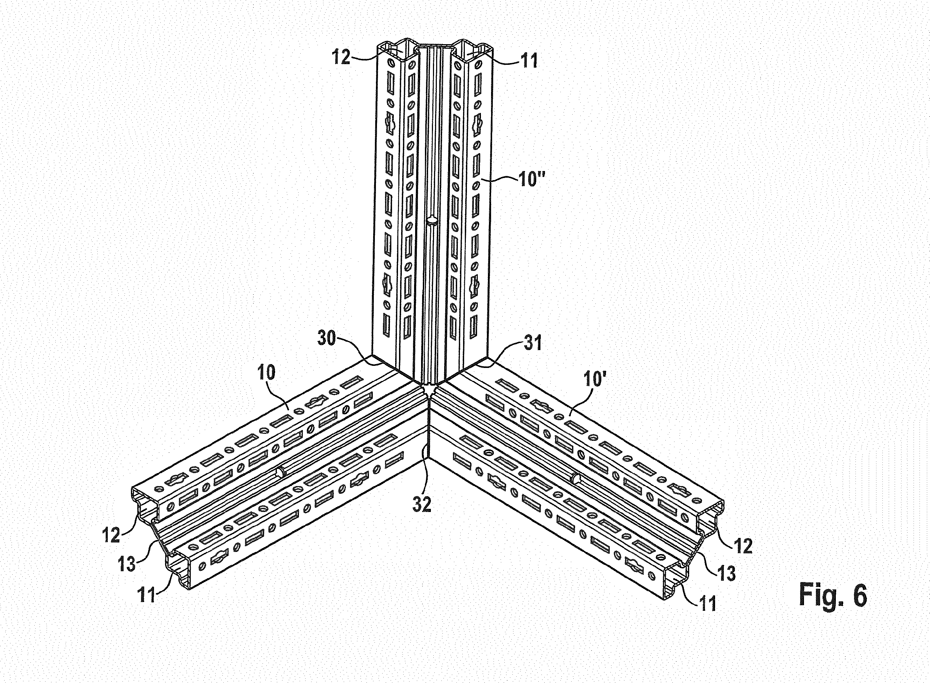

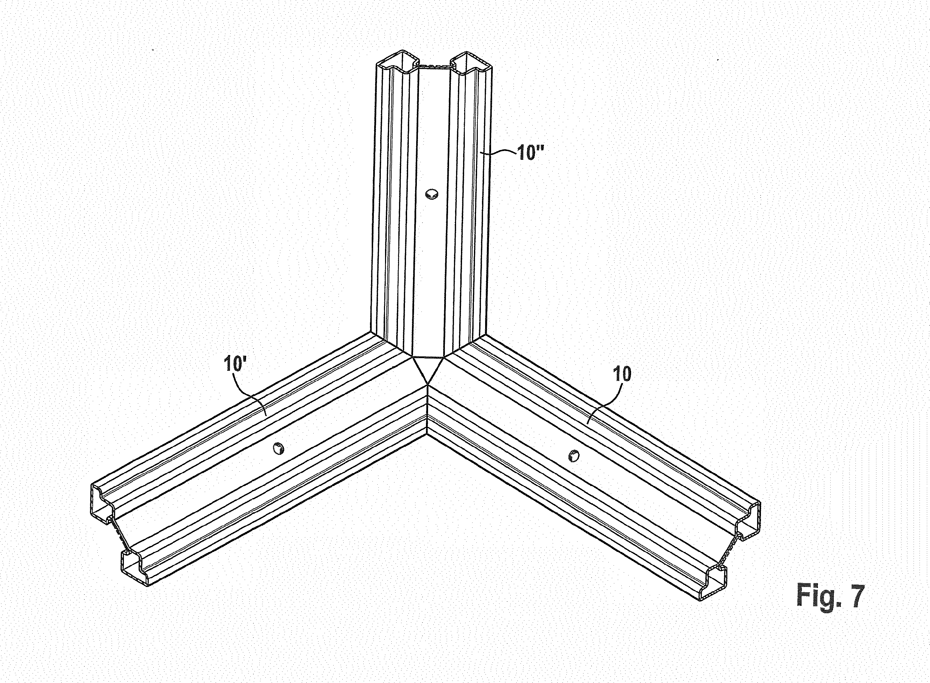

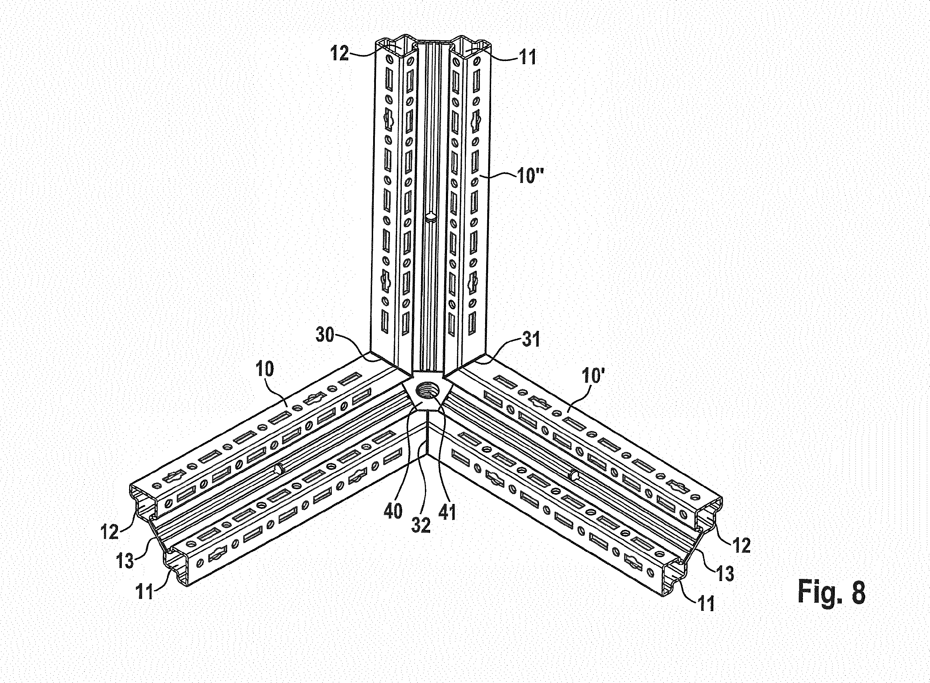

Figur 6 zeigt ein Beispiel für eine Eckverbindung gemäß der vorliegenden Erfindung nach einem zweiten Aspekt, bei dem auf einen Eckverbinder verzichtet wird. Die horizontalen Profile 10 sind so zugeschnitten, dass sie im Bodenbereich des Rahmengestells unter einem Winkel von 45° aufeinander treffen, so dass sich eine 90° Verbindung ergibt. Ebenso ist das vertikale Profil 10" auf 45° zugeschnitten, so dass sich in Kombination mit den horizontalen Profilen 10, 10" die erwünschte 90°-Verbindung ergibt. In Belastungsrichtung sind jeweils Schweißverbindungen 30, 31, 32 angebracht. Es kann weiterhin, wie in Figur 8 zu sehen ist, ein Montageklotz 40 vorgesehen sein, der eine Gewindeöffnung 41, beispielsweise für einen Standfuß oder eine Kranöse enthält. Figur 7 zeigt die Eckverbindung der Figur 6 um 180° gedreht und verkippt, also sozusagen von außen betrachtet, als auch optisch ansprechende Anordnung.

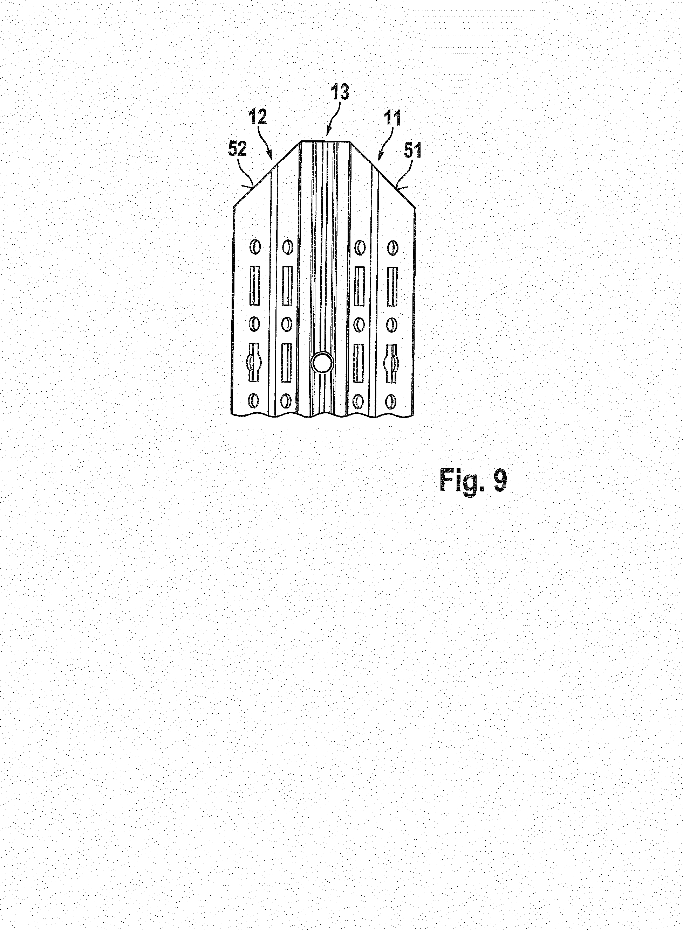

Schließlich zeigt Figur 9, wie die Profile gemäß Figur 6 in vorteilhafter Weise angeschnitten werden. Die 45°-Schnitte 51, 52 erstrecken sich lediglich über den Querschnitt der Kammern 11 beziehungsweise 12, so dass der Verbindungssteg 13 unversehrt bleibt und seine Verwindungssteifigkeit behält.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

## Patentansprüche

1. Schaltschranksystem, mit
- wenigstens einem Rahmengestell (1), das die Kontur einer Schaltschrankeinheit definiert,
- wenigstens einer Entwärmungskomponente zum Abführen oder Ableiten von Wärme, die von in oder an dem Rahmengestell angeordneten elektrischen oder elektronischen Komponenten erzeugt wird, und
- Schnittstellen zur Kommunikation mit der Umgebung des Schaltschranksystems,
wobei das Rahmengestell (1) aus vertikal und horizontal anzuordnenden Profilen (10) mit Systemlochung aufgebaut ist, die an ihren Enden senkrecht zur Profilrichtung abgelängt sind, wobei die Profile Hohlprofile sind und der Profilquerschnitt aller Profile (10) des Rahmengestells (1) identisch ist, und
wobei jeweils drei der Profile (10) mittels Eckverbindern (20) senkrecht zueinander positioniert sind, die in mindestens zwei der Profile eingreifen,
**dadurch gekennzeichnet, dass** im Verbindungsbereich der Profile (10) in Belastungsrichtung verlaufende Schweißnähte angebracht sind.

2. Schaltschranksystem nach Anspruch 1, **dadurch gekennzeichnet, dass** die Profile (10) des Rahmengestells einen gerade verlaufenden Verbindungssteg (13) aufweisen, von dem aus sich, symmetrisch zu der Längsrichtung des Profils, auf beiden Seiten jeweils eine Hohlkammer (11, 12) erstreckt.

3. Schaltschranksystem nach Anspruch 1 oder 2, **dadurch gekennzeichnet, dass** die Eckverbinder (20) des Rahmengestells Zapfen (21, 22) aufweisen, wobei der Querschnitt der Zapfen (21, 22) dem Querschnitt einer Hohlkammer (11, 12) des Profils entspricht.

4. Schaltschranksystem nach Anspruch 1 oder 2, **dadurch gekennzeichnet, dass** der Querschnitt einer Hohlkammer (11, 12) des Profils einen Bereich mit L-förmiger Kontur umfasst und dass der Querschnitt der Zapfen (21' 22') dem Bereich mit L-förmiger Kontur entspricht.

5. Schaltschranksystem nach Anspruch 4, **dadurch gekennzeichnet, dass** die Querschnittsfläche der Hohlkammer (11, 12) größer ist als die Querschnittsfläche des Zapfens (21', 22').

6. Schaltschranksystem nach Anspruch 1, **dadurch gekennzeichnet, dass** in die Eckverbinder (20) des Rahmengestells jeweils eine Gewindeöffnung (23) zur Aufnahme einer Kranöse oder eines Standfußes integriert ist.

7. Schaltschranksystem, mit
- wenigstens einem Rahmengestell (1), das die Kontur einer Schaltschrankeinheit definiert,
- wenigstens einer Entwärmungskomponente zum Abführen oder Ableiten von Wärme, die von in oder an dem Rahmengestell, angeordneten elektrischen oder elektronischen Komponenten erzeugt wird, und
- Schnittstellen zur Kommunikation mit der Umgebung des Schaltschranksystems,
wobei das Rahmengestell (1) aus vertikal und horizontal anzuordnenden Profilen (10, 10', 10") mit Systemlochung aufgebaut ist, die an ihren Enden zumindest abschnittsweise unter einem vorbestimmten Winkel oder um vorbestimmte Winkel zur Profilrichtung, der bzw. die ungleich 90° ist, abgelängt sind, wobei die Profile Hohlprofile sind und der Profilquerschnitt aller Profile des Rahmengestells identisch ist, und
wobei die Ablängungen so gewählt sind, dass jeweils drei der Profile (10, 10'; 10") senkrecht zueinander aneinanderliegend zu positionieren sind, um eine Ecke zu bilden, **dadurch gekennzeichnet, dass** im Verbindungsbereich der Profile (10, 10', 10") in Belastungsrichtung verlaufende Schweißnähte (30, 31, 32) angebracht sind.

8. Schaltschranksystem nach Anspruch 7, **dadurch gekennzeichnet, dass** die Profile des Rahmengestells einen gerade verlaufenden Verbindungssteg (13) aufweisen, von dem aus sich, symmetrisch zu der Längsrichtung des Profils, auf beiden Seiten jeweils eine Hohlkammer (11, 12) erstreckt.

9. Schaltschranksystem nach Anspruch 8, **dadurch gekennzeichnet, dass** bei wenigstens einem der Profile die winklige Ablängung lediglich über zumindest eine der Hohlkammern (11, 12) erfolgt.

10. Schaltschranksystem nach einem der Ansprüche 7 bis 9, **dadurch gekennzeichnet, dass** in den Bereich jeder Ecke des Rahmengestells jeweils eine Gewindeöffnung (41) zur Aufnahme einer Kranöse oder eines Standfußes integriert ist.
